(19) **Europäisches Patentamt European Patent Office Office européen des brevets**

(11) **EP 3 237 895 B1**

(12) **FASCICULE DE BREVET EUROPEEN**

(45) Date de publication et mention de la délivrance du brevet:
**12.09.2018 Bulletin 2018/37**

(51) Int Cl.:
**G01N 27/04** (2006.01)   **G01N 27/14** (2006.01)
**H01L 21/66** (2006.01)

(21) Numéro de dépôt: **15823682.8**

(22) Date de dépôt: **18.12.2015**

(86) Numéro de dépôt international:
**PCT/FR2015/053639**

(87) Numéro de publication internationale:
**WO 2016/102851 (30.06.2016 Gazette 2016/26)**

(54) **PROCEDE DE DETERMINATION D'UNE CONTAMINATION INTRODUITE DANS UN MATERIAU SEMI-CONDUCTEUR**

**VERFAHREN ZUR BESTIMMUNG DER KONTAMINATION IN EINEM HALBLEITERMATERIAL**

**METHOD FOR DETERMINING CONTAMINATION INTRODUCED INTO A SEMICONDUCTOR MATERIAL**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.12.2014 FR 1463324**

(43) Date de publication de la demande:
**01.11.2017 Bulletin 2017/44**

(73) Titulaire: **Commissariat à l'Énergie Atomique et aux Énergies Alternatives 75015 Paris (FR)**

(72) Inventeurs:
• **MARTEL, Benoît**
 **73200 Gilly Sur Isere (FR)**
• **DUBOIS, Sébastien**
 **74950 Scionzier (FR)**
• **VEIRMAN, Jordi**
 **74330 Poisy (FR)**

(74) Mandataire: **Cabinet Camus Lebkiri 25 rue de Maubeuge 75009 Paris (FR)**

(56) Documents cités:
**EP-A1- 2 803 985**

• **M GAROUM ET AL: "Mapping rules for Arrhenius plots, for models provided with one or two donor levels compensated by deep acceptors", JOURNAL OF PHYSICS D: APPLIED PHYSICS, vol. 28, no. 1, 14 janvier 1995 (1995-01-14), pages 138-148, XP055225153, GB ISSN: 0022-3727, DOI: 10.1088/0022-3727/28/1/021**
• **DUSTIN A WOODBURY ET AL: "Impurity Conduction and the Metal-Nonmetal Transition m Manuanese-Doped Gallium Arsenide", PHYSICAL REVIEW B, vol. 8, no. 15, 15 octobre 1973 (1973-10-15), pages 3803-3810, XP055225211,**

**EP 3 237 895 B1**

**Description**

**DOMAINE TECHNIQUE DE L'INVENTION**

Le domaine technique de l'invention est celui de l'industrie des matériaux semi-conducteurs, et plus particulièrement celui du contrôle de la qualité des matériaux semi-conducteurs.
L'invention se rapporte à un procédé de détermination d'une contamination introduite dans un matériau semi-conducteur par un équipement lors d'un traitement thermique.

**ARRIERE-PLAN TECHNOLOGIQUE DE L'INVENTION**

Les performances des dispositifs photovoltaïques ou électroniques à base de matériau semi-conducteur dépendent fortement de la pureté du matériau semi-conducteur utilisé. Des impuretés, même en nombre limité, introduites dans le matériau semi-conducteur peuvent fortement dégrader ses propriétés, notamment la durée de vie des porteurs de charge. Ces impuretés sont le plus souvent de nature métallique. Par exemple, dans le silicium, lorsque la teneur en fer atteint $3.10^{12}$ cm$^{-3}$, la durée de vie des porteurs de charge est d'environ 2,5 $\mu$s, alors qu'actuellement l'industrie photovoltaïque s'oriente vers l'utilisation de plaquettes pour lesquelles les durées de vie des porteurs de charge sont supérieures à 1 ms. Il est donc crucial de limiter la contamination des matériaux semi-conducteurs par des impuretés.
Cependant, les dispositifs photovoltaïques ou les circuits intégrés sont généralement fabriqués au moyen d'étapes de recuit à haute température (étapes de diffusion superficielle des dopants, d'activation des dopants implantés, étapes de recuit rapide pour le frittage des pâtes de métallisation, étapes PECVD (« Plasma-Enhanced Chemical Vapor Déposition ») pour le dépôt de couches diélectriques, ...). Les températures élevées de ces recuits, typiquement dans l'intervalle 200°C-1300°C, favorisent la contamination des matériaux semi-conducteurs par des impuretés initialement présentes dans l'enceinte du four de recuit. En effet, les contaminants du four ont tendance à diffuser dans le matériau semi-conducteur sous l'effet de la température. Il convient alors de s'assurer de la « propreté » du four de recuit et de la contrôler régulièrement.
Il existe des techniques d'analyses de la contamination des matériaux semi-conducteurs survenant lors de traitements thermiques. Par exemple, pour contrôler des tubes de traitement à haute température, il est fréquent d'utiliser des analyses de type SIMS (« Second Ion Mass Spectrometry ») ou VPD-ICPMS (« Vapor Phase Decomposition Inductively Coupled Plasma Mass Spectrometry »). Ces techniques sont lourdes à mettre en oeuvre. Les équipements sont onéreux et demandent une main d'oeuvre qualifiée. Enfin, les limites de détection de ces équipements ne sont pas toujours compatibles avec les exigences des industries photovoltaïques et de la micro-électronique.
Un autre procédé d'analyse de la contamination d'un four consiste à effectuer des mesures, par exemple par décroissance de la photoconductivité PCD (« PhotoConductivity Decay » en anglais), de la durée de vie des porteurs de charge sur un matériau semi-conducteur initialement pur ayant subi l'étape de recuit d'intérêt. Cependant, pour que la mesure soit sensible aux défauts volumiques, il est nécessaire d'effectuer des étapes de passivation électrique des surfaces, qui sont chronophages et surtout, qui pourraient entraîner une sur-contamination de l'échantillon, puisqu'elles s'effectuent également à haute température.

**RESUME DE L'INVENTION**

Le procédé selon l'invention vise à résoudre les problèmes qui viennent d'être exposés en proposant une alternative rapide et simple à mettre en oeuvre pour la détermination d'une contamination introduite par un équipement au sein d'un matériau semi-conducteur. Le procédé selon l'invention est de plus adapté à la détection de très faibles contaminations.
L'invention concerne donc un procédé de détermination d'une contamination introduite par un équipement au sein de deux échantillons constitués d'un matériau semi-conducteur non compensé en impuretés dopantes, les deux échantillons ayant des types de conductivité opposés et comportant chacun des impuretés dopantes majoritaires dont le type de conductivité et la concentration sont connus, le procédé comportant les différentes étapes consistant à :

a) soumettre chacun des deux échantillons à un traitement thermique dans l'équipement, la contamination introduite par l'équipement lors du traitement thermique se traduisant par l'apparition d'impuretés dopantes, dont le type de conductivité et la concentration sont inconnus, au sein des deux échantillons, les impuretés dopantes dues à la contamination étant minoritaires dans au moins un des deux échantillons traités ;
b) mesurer dans chacun des deux échantillons traités la densité de porteurs de charge en fonction de la température ;
c) définir pour chacun des deux échantillons traités une courbe représentant le logarithme de la densité de porteurs de charge en fonction de l'inverse de la température ;
d) détecter, pour ledit au moins un des deux échantillons traités, la position d'un changement de pente dans une

2

zone de la courbe correspondant à un régime d'ionisation des impuretés dopantes ;

e) déterminer la concentration des impuretés dopantes minoritaires dudit au moins un des deux échantillons traités à partir de la position du changement de pente.

On entend par type de conductivité le type des porteurs de charge qui assurent la conduction électrique. Les impuretés dopantes à caractère accepteur (amenant des trous) ont une conductivité de type p, et les impuretés dopantes à caractère donneur (amenant des électrons) ont une conductivité de type n.

On entend par traitement thermique toute opération consistant à faire subir à un échantillon une variation (positive ou négative) de température afin d'en modifier les propriétés, par exemple physiques, électriques ou mécaniques. Un recuit et une cristallisation sont deux exemples d'un traitement thermique.

Le procédé selon l'invention peut comporter, en plus des étapes principales qui viennent d'être mentionnées dans le paragraphe précédent, une ou plusieurs caractéristiques parmi les suivantes considérées individuellement ou selon les combinaisons techniquement possibles :

- les étapes a) à e) sont répétées pour une pluralité d'échantillons d'un même type de conductivité et ayant des concentrations en impuretés dopantes majoritaires différentes ;
- la courbe représentant le logarithme de la densité de porteurs de charge en fonction de l'inverse de la température est définie en étant tracée graphiquement ;
- la contamination introduite par l'équipement lors du traitement thermique se traduit par l'apparition, au sein de l'un des deux échantillons traités, d'impuretés dopantes minoritaires d'un premier type de conductivité, et par l'apparition, au sein de l'autre des deux échantillons traités, d'impuretés dopantes minoritaires d'un deuxième type de conductivité opposé au premier type de conductivité, les étapes d) et e) étant réalisées pour les deux échantillons traités.

- les mesures de la densité de porteurs de charge sont effectuées à des températures comprises dans un régime de conduction de bande, dont la limite basse dépend du dopage de l'échantillon, en général dans une plage comprise entre 20K et 300K.
- la densité de porteurs de charge en fonction de la température est mesurée par effet Hall.

De préférence, la concentration des impuretés dopantes minoritaires dudit au moins un des deux échantillons traités est déterminée au moyen d'un abaque associé à la concentration connue en impuretés dopantes majoritaires. L'abaque associé à la concentration connue en impuretés dopantes majoritaires est avantageusement une courbe représentant la position du changement de pente en fonction de la concentration des impuretés dopantes minoritaires. Cet abaque est par exemple obtenu à l'aide des étapes suivantes :

- calculer la densité de porteurs de charge en fonction de la température pour une pluralité de degrés de compensation, chaque degré de compensation étant défini comme le rapport entre une concentration en impuretés dopantes minoritaires et la concentration connue des impuretés dopantes majoritaires ;
- tracer, pour chaque degré de compensation, une courbe représentant le logarithme de la densité de porteurs de charge en fonction de l'inverse de la température ;
- calculer, pour chaque degré de compensation, la dérivée seconde de la courbe représentant le logarithme de la densité de porteurs de charge en fonction de l'inverse de la température ;
- déterminer, pour chaque degré de compensation, la position du minimum local de la dérivée seconde ayant la plus faible température et correspondant à un changement de pente dans une zone de la courbe correspondant à un régime d'ionisation des dopants ;
- tracer une courbe représentant la position du changement de pente en fonction de la concentration en impuretés dopantes minoritaires.

Dans un premier mode de mise en oeuvre du procédé selon l'invention, l'équipement est un four, le traitement thermique étant un recuit. Les deux échantillons sont avantageusement soumis au recuit simultanément.

Dans un deuxième mode de mise en oeuvre du procédé selon l'invention, l'équipement est un creuset, le traitement thermique de chacun des deux échantillons comprenant les différentes opérations consistant à :

- fondre une charge du matériau semi-conducteur dans le creuset ;
- cristalliser la charge du matériau semi-conducteur fondue sous la forme d'un lingot.

Le traitement thermique de chacun des deux échantillons est de préférence suivi d'une opération consistant à découper une plaquette dans chacun des deux lingots.

L'invention et ses différentes applications seront mieux comprises à la lecture de la description qui suit et à l'examen des figures qui l'accompagnent.

**BREVE DESCRIPTION DES FIGURES**

Les figures ne sont présentées qu'à titre indicatif et nullement limitatif de l'invention. Elles montrent :

- à la figure 1, l'allure de la variation du logarithme de la densité de porteurs de charges en fonction de l'inverse de la température pour un matériau semi-conducteur de type p non compensé et pour un matériau semi-conducteur de type p compensé ;
- à la figure 2, le logarithme de la densité de porteurs de charge en fonction de l'inverse de la température d'un échantillon de silicium de type p, pour différent degrés de compensation en dopants ;
- à la figure 3, un diagramme fonctionnel d'un mode de mise en oeuvre du procédé selon l'invention ;
- à la figure 4, un diagramme fonctionnel d'un mode de réalisation d'un abaque associé à une concentration connue en dopants majoritaires ;
- à la figure 5, des courbes représentant, pour divers degrés de compensation, le logarithme de la densité de porteurs de charge en fonction de l'inverse de la température, pour un échantillon de silicium de type p dopé au bore à une concentration de $10^{16}$ cm$^{-3}$ ;
- à la figure 6, des courbes représentant, pour divers degrés de compensation, la dérivée seconde des courbes de logarithme de la figure 5 ;
- à la figure 7, un abaque construit pour quatre échantillons de silicium non compensé de type p dopés au bore à des concentrations de $10^{12}$ cm$^{-3}$, $10^{14}$ cm$^{-3}$, $10^{16}$ cm$^{-3}$ et $10^{17}$ cm$^{-3}$ ;
- à la figure 8, un abaque construit pour quatre échantillons de silicium de type n non compensé dopés au phosphore à des concentrations de $10^{12}$ cm$^{-3}$, $10^{14}$ cm$^{-3}$, $10^{16}$ cm$^{-3}$ et $10^{17}$ cm$^{-3}$ ;
- à la figure 9, des courbes représentant le logarithme de la densité de porteurs de charge en fonction de l'inverse de la température, pour deux échantillons de silicium initialement non compensé de type n dopé au phosphore à des concentrations de $2{,}45.10^{16}$ cm$^{-3}$ et $1{,}73.10^{17}$ cm$^{-3}$, avant et après un recuit dans un four ;
- à la figure 10, des courbes représentant la dérivée seconde des courbes de logarithme de la figure 9 après recuit ;
- à la figure 11, un abaque construit pour les deux échantillons de silicium non compensé de type n de la figure 9 ;
- à la figure 12, deux courbes représentant le logarithme de la densité de porteurs de charge en fonction de l'inverse de la température ainsi que sa dérivée seconde, pour un échantillon de silicium initialement non compensé de type p dopé au bore à une concentration de $4.10^{16}$ cm$^{-3}$, après un recuit dans un four ;
- à la figure 13, un abaque construit pour l'échantillon de silicium non compensé de type p de la figure 12.

**DESCRIPTION DETAILLEE D'UN MODE DE REALISATION DE L'INVENTION**

La contamination d'un matériau semi-conducteur se traduit par l'apparition d'impuretés dans le matériau. On parle de contamination dans le sens où la présence de ces impuretés dans le matériau semi-conducteur n'est pas souhaitée car elles peuvent en modifier les propriétés électriques. Ces impuretés sont par exemple des atomes ou des ions métalliques, des atomes d'oxygène, de carbone, d'azote ou d'hydrogène.

Les impuretés dues à la contamination peuvent être des impuretés dopantes si elles introduisent un niveau d'énergie dans la bande interdite du matériau semi-conducteur. Si le niveau d'énergie introduit se situe à proximité de la bande de valence, les impuretés dues à la contamination sont des impuretés dopantes à caractère accepteur, également appelées impuretés dopantes de type p. Inversement, si le niveau d'énergie introduit se situe à proximité de la bande de conduction, les impuretés dues à la contamination sont des impuretés dopantes à caractère donneur, également appelées impuretés dopantes de type n.

Les impuretés dopantes dues à la contamination, appelées plus simplement « contaminants », diffèrent des impuretés dopantes sciemment introduites dans le matériau semi-conducteur dans le but de modifier sa conductivité électrique. Dans la description qui suit, le terme générique « dopants » est utilisé lorsqu'on souhaite distinguer ces impuretés dopantes des contaminants. Les dopants peuvent aussi être à caractère accepteur (de type p), comme le bore dans le silicium, ou à caractère donneur (de type n), comme le phosphore dans le silicium.

Lorsque la concentration des impuretés dopantes à caractère accepteur est supérieure à la concentration des impuretés dopantes à caractère donneur, les impuretés dopantes à caractère accepteur sont qualifiées de « majoritaires » et les impuretés dopantes à caractère donneur sont qualifiées de « minoritaires ». Le matériau semi-conducteur possède alors une conductivité dite de type p.

Inversement, lorsque la concentration des impuretés dopantes à caractère donneur est supérieure à la concentration des impuretés dopantes à caractère accepteur, les impuretés dopantes à caractère donneur sont qualifiées de « majoritaires » et les impuretés dopantes à caractère accepteur sont qualifiées de « minoritaires ». Le matériau semi-conducteur possède alors une conductivité dite de type n.

Par ailleurs, lorsque le matériau semi-conducteur comporte des impuretés dopantes ayant un seul type de conductivité, le matériau semi-conducteur est dit non compensé en impuretés dopantes. Par contre, lorsque le matériau semi-conducteur comporte simultanément des impuretés dopantes à caractère accepteur et des impuretés dopantes à caractère donneur, le matériau semi-conducteur est dit compensé en impuretés dopantes. Le degré de compensation du matériau semi-conducteur est alors défini comme étant le rapport de la concentration des impuretés dopantes minoritaires sur la concentration des impuretés dopantes majoritaires.

La statistique de Fermi-Dirac permet de décrire la variation de la densité de porteurs de charge en fonction de la température dans le matériau semi-conducteur. Dans un échantillon de type n compensé par des impuretés dopantes de type p, la concentration en porteurs de charge (des électrons) est donnée par l'équation suivante :

$$n_0(T) = -\frac{1}{2}\left(N_A + \frac{N_C}{2}e^{\left(-E_a/kT\right)}\right) + \frac{1}{2}\left[(N_A + \frac{N_C}{2}e^{\left(-E_a/kT\right)})^2 + 2N_c e^{\left(-E_a/kT\right)}(N_D - N_A)\right]^{\frac{1}{2}} \qquad (1)$$

où $E_a$ est l'énergie d'activation des impuretés dopantes à caractère donneur, $N_A$ est la densité d'impuretés dopantes à caractère accepteur, $N_D$ est la densité d'impuretés dopantes à caractère donneur, $N_C$ est la densité d'états effective de la bande de conduction, k est la constante de Boltzmann et T est la température.

Dans un échantillon de type p compensé par des impuretés dopantes de type n, la concentration en porteurs de charge (des trous) est donnée par l'équation suivante :

$$p_0(T) = -\frac{1}{4}\left(N_D + \frac{N_V}{4}e^{\left(-E_a/kT\right)}\right) + \frac{1}{2}\left[(N_D + \frac{N_V}{4}e^{\left(-E_a/kT\right)})^2 + N_V e^{\left(-E_a/kT\right)}(N_A - N_D)\right]^{\frac{1}{2}} \qquad (2)$$

où $E_a$ est l'énergie d'activation des impuretés dopantes à caractère accepteur et $N_V$ est la densité d'états effective de la bande de valence

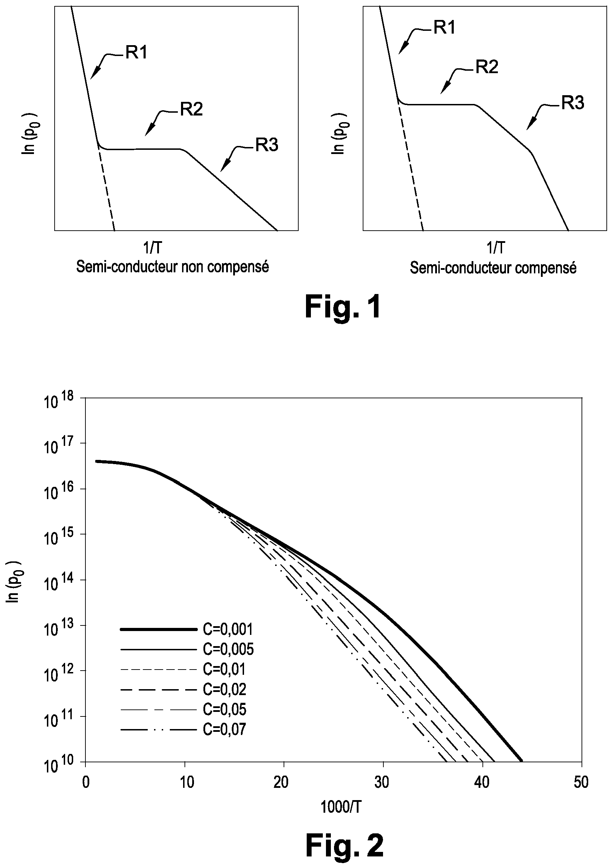

La figure 1 représente le logarithme de la densité de porteurs de charge en fonction de l'inverse de la température, par exemple pour un échantillon de matériau semi-conducteur de type p, calculé à partir de l'équation (1). On obtient une courbe comportant trois zones distinctes correspondant chacune à un régime de conduction particulier : le régime intrinsèque R1 correspondant aux températures les plus élevées, le régime de saturation R2, également appelé régime d'épuisement R2, correspondant aux températures intermédiaires et le régime d'ionisation R3, également appelé régime de gel des porteurs R3, correspondant aux températures les plus faibles.

Dans le régime d'ionisation R3, lorsque la température baisse, l'énergie thermique devient progressivement insuffisante pour qu'un atome dopant puisse libérer sa charge dans la bande de valence ou dans la bande de conduction, selon le type de conductivité de l'atome dopant. Autrement dit, plus la température baisse, plus les atomes dopants ont une forte probabilité de perdre leur caractère ionique.

Dans le cas où le matériau semi-conducteur est non compensé, à gauche sur la figure 1, on observe une unique pente dans la zone correspondant au régime d'ionisation R3. Par contre, dans le cas où le matériau semi-conducteur est compensé, à droite sur la figure 1, deux pentes apparaissent dans cette même zone R3. Ce phénomène est appelé « double pente ».

La figure 2 montre le logarithme de la densité de porteurs de charge en fonction de l'inverse de la température (ici 1000/T) dans la zone correspondant au régime d'ionisation R3 d'un échantillon de silicium de type p dopé au bore à une concentration de $10^{16}$ cm$^{-3}$, pour différent degrés de compensation C.

On remarque que le comportement de la courbe varie en fonction du degré de compensation. En effet, plus le degré de compensation est faible, plus le phénomène de double pente est marqué et plus la température pour laquelle le changement de pente se produit est faible. Il existe une limite haute du degré de compensation, de l'ordre de $10^{-1}$, à partir de laquelle le phénomène de double pente n'apparaît plus.

On décrit ci-dessous un procédé de caractérisation qui exploite ce phénomène de double pente et permet de déterminer une contamination introduite par un équipement au sein d'un matériau semi-conducteur lors d'un traitement thermique. Pour cela, le matériau semi-conducteur, initialement non compensé, est soumis au traitement thermique dans l'équipement à caractériser. On se retrouve alors dans le cas de figure précédemment décrit où la contamination introduite par l'équipement dans le matériau semi-conducteur se traduit par l'apparition de contaminants ayant un type de conductivité opposé à celui des dopants majoritaires du matériau semi-conducteur non compensé.

Le phénomène de double pente est alors observable car le matériau semi-conducteur est dorénavant compensé. En déterminant la température pour laquelle survient le changement de pente, on peut en déduire le degré de compensation et donc la concentration des impuretés dopantes minoritaires, c'est-à-dire la concentration des contaminants.

Dans ce procédé, on utilise deux échantillons du matériau semi-conducteur non compensé ayant des types de conductivité opposés. Le matériau semi-conducteur est, par exemple, du silicium. L'un des deux échantillons en silicium est donc de type p et l'autre échantillon est de type n. De plus, la concentration des dopants dans chacun des deux échantillons est connue. Les deux échantillons sont choisis de manière à ce que les dopants soient majoritaires et que les contaminants soient minoritaires, et de manière à ce que le degré de compensation n'excède pas $10^{-1}$, limite haute du phénomène de double pente. En pratique, cela revient à choisir des concentrations en dopants majoritaires environ 10 fois supérieure à la concentration attendue de contaminants (i.e. les impuretés dopantes minoritaires).

Si la concentration des dopants majoritaires de chacun des deux échantillons en silicium non compensé n'est pas connue, il est possible de la déterminer par exemple à partir de la valeur de la résistivité de chacun des deux échantillons, cette valeur de la résistivité étant fournie par le fabricant de l'échantillon ou mesurée, par exemple par la méthode des quatre pointes.

Deux échantillons, l'un de type p et l'autre de type n, sont utilisés car on ignore le type de conductivité des contaminants introduits par l'équipement. Pour que la contamination puisse être observée, les contaminants doivent pouvoir être distinguées des dopants de l'échantillon et donc avoir un type de conductivité opposé à celui des dopants majoritaires.

Ainsi, avec les deux types de dopage, i.e. avec des dopants majoritaires à caractère accepteur dans l'un des deux échantillons et des dopants majoritaires à caractère donneur dans l'autre échantillon, les contaminants introduits par l'équipement se retrouvent nécessairement minoritaires dans au moins un des deux échantillons. C'est également pour cette raison qu'on utilise deux échantillons de matériau semi-conducteur non compensé, afin que les contaminants ne soient pas « noyées » parmi des dopants minoritaires initialement présents dans les deux échantillons et ayant le même type de conductivité.

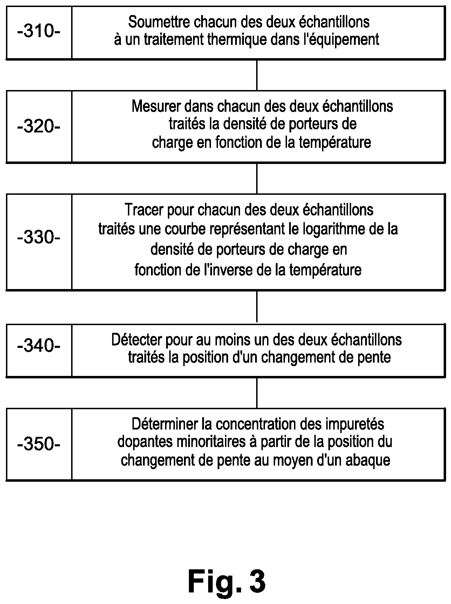

La figure 3 représente un diagramme fonctionnel d'un mode de mise en oeuvre du procédé selon l'invention. Les deux échantillons sont d'abord soumis, au cours d'une étape 310, à un traitement thermique dans l'équipement.

Dans un premier mode de mise en oeuvre préférentiel du procédé, l'équipement est un four et le traitement thermique est un recuit. Ce procédé permet alors un contrôle régulier des fours de recuit utilisés dans l'industrie photovoltaïque ou microélectronique. Cela est particulièrement avantageux, car ces fours de recuit sont utilisés intensivement dans les procédés de fabrication des dispositifs (circuits intégrés, cellules photovoltaïques...) au travers d'étapes de diffusion superficielle des dopants, d'activation des dopants implantés, d'étapes de recuit rapide pour le frittage des pâtes de métallisation, d'étapes PECVD pour le dépôt de couches diélectriques... Avantageusement, les deux échantillons de matériau semi-conducteur, généralement sous la forme de plaquettes, sont soumis simultanément au recuit. La contamination introduite par le four peut ainsi être considérée comme étant la même dans chacun des deux échantillons.

Dans un second mode de mise en oeuvre, l'équipement que l'on cherche à caractériser est un creuset. Les deux échantillons de matériau semi-conducteur sont initialement à l'état de charge, l'une de type p et l'autre de type n. Chaque charge du matériau semi-conducteur est d'abord fondue dans le creuset, puis cristallisée sous la forme d'un lingot. Les deux échantillons sont évidemment soumis de façon successive à ce traitement thermique. Néanmoins, la contamination introduite par le creuset est considérée comme étant la même dans chacun des deux échantillons. Ainsi, dans ce second mode de mise en oeuvre, les échantillons traités sont sous la forme de lingots.

Pour faciliter ce second mode de mise en oeuvre, et notamment l'étape de mesure 320 décrite ci-après, la cristallisation peut être suivie d'une opération consistant à découper une plaquette dans chacun des deux lingots. Les échantillons traités sont alors sous la forme de plaquettes, plutôt que de lingots. Chaque plaquette est avantageusement découpée dans la partie du lingot cristallisée en dernier. En effet, à cause du phénomène de ségrégation, la partie du lingot cristallisée en dernier est celle où la concentration en impuretés, à la fois les dopants et les contaminants, est la plus élevée. La contamination est alors plus facilement détectable, les contaminants étant présents en plus grande quantité (le degré de compensation restant suffisamment faible). Toutefois, une fois que la contamination dans cette partie est connue, il est possible grâce à la loi de Scheil de déterminer la contamination en contaminants dans le reste du lingot et la concentration en contaminants dans la charge initiale de silicium.

A la suite du traitement thermique 310, on procède à une étape de mesure 320 (Fig.3), dans chacun des échantillons traités (ex. plaquettes passées au recuit, lingots ou plaquettes découpées dans les lingots), de la densité de porteurs de charge en fonction de la température. Les mesures s'effectuent avantageusement à des températures comprises entre 20K et 300K, cette plage de température englobant le régime d'ionisation R3, ce qui permet d'observer le changement de pente. De plus, dans cette plage de température, les mesures n'introduisent pas de nouvelle contamination dans les échantillons traités. Pour mesurer la densité de porteurs de charge en fonction de la température, on utilise avantageusement une technique de mesure par effet Hall, compatible avec la plage de température définie précédemment.

A partir des mesures effectuées à l'étape 320, une courbe représentant le logarithme de la densité de porteurs de charge en fonction de l'inverse de la température est définie, par exemple en la traçant graphiquement, pour chacun des échantillons traités, lors d'une étape 330. De préférence, la courbe est définie par la relation suivante :

$$\ln\left(p_0 * T^{-\frac{3}{2}}\right) = f\left(\frac{1000}{T}\right) \qquad (3)$$

afin de prendre en compte la variation des paramètres $N_V$ et $N_C$ en fonction de la température, variation proportionnelle à $T^{3/2}$, et améliorer la précision du procédé de détermination de la contamination.

On détecte ensuite, au cours d'une étape 340, pour au moins une des deux courbes représentant le logarithme de la densité de porteurs de charge en fonction de l'inverse de la température, la position d'un changement de pente dans la zone correspondant au régime d'ionisation. L'étape de détection 340 est par exemple effectuée en calculant la dérivée seconde du logarithme de la densité de porteurs de charge en fonction de l'inverse de la température et en déterminant un minimum local de cette dérivée seconde dans la plage de température correspondant au régime d'ionisation.

La concentration des impuretés dopantes minoritaires (i.e. des contaminants) de l'échantillon traité pour lequel on a constaté un changement de pente est alors déterminée au cours d'une étape 350. Pour ce faire, un abaque donnant la position du changement de pente en fonction de la concentration en impuretés dopantes minoritaires peut être utilisé. La position du changement de pente déterminée à l'étape F3 est reportée sur l'abaque associé à la concentration connue en dopants majoritaires de cet échantillon, puis on lit la concentration en impuretés dopantes minoritaires correspondante.

L'équipement peut provoquer une contamination introduisant à la fois des impuretés de type p et des impuretés de type n, auquel cas le phénomène de double pente est présent pour les deux courbes représentant le logarithme de la densité de porteurs de charge en fonction de l'inverse de la température des deux échantillons traités.

Dans ce cas, l'étape de détection 340 de la position d'un changement de pente dans la zone correspondant au régime d'ionisation est alors effectuée pour les deux échantillons traités. De même, l'étape de détermination 350 de la concentration des contaminants minoritaires est effectuée pour les deux échantillons traités, en utilisant deux abaques distincts, chacun des deux abaques étant associé à la concentration connue en dopants majoritaires de l'un des deux échantillons traités.

De façon avantageuse, les étapes 310 à 350 du procédé de la figure 3 selon l'invention sont répétées pour différentes valeurs de la concentration en dopants majoritaires, c'est-à-dire pour plusieurs échantillons de type p ayant des concentrations en dopants majoritaires différentes et/ou pour plusieurs échantillons de type n ayant également des concentrations en dopants majoritaires différentes. Cela permet d'augmenter la précision du résultat, par exemple en effectuant la moyenne des différentes valeurs de la concentration des contaminants obtenues à partir de cette pluralité d'échantillons.

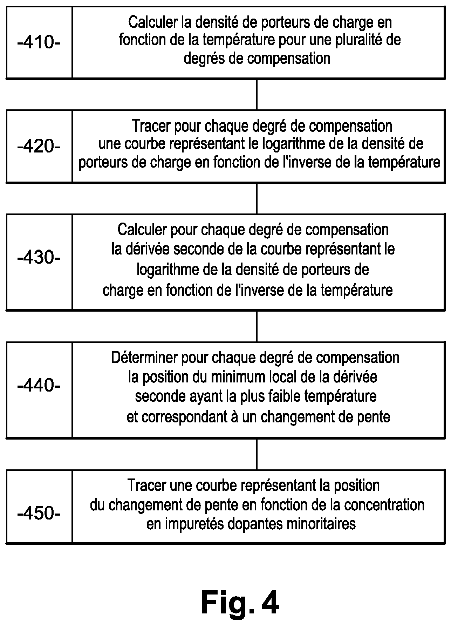

La figure 4 représente un diagramme fonctionnel d'un mode de réalisation d'un abaque utilisé dans l'étape de détermination 350 décrite précédemment. En utilisant les équations (1) et (2) de la statistique de Fermi-Dirac, la densité des porteurs de charge en fonction de la température est calculée, au cours d'une étape 410, pour divers degrés de compensation. Ces degrés de compensation ont la même concentration en impuretés dopantes majoritaires. Ainsi, seule la concentration en impuretés dopantes minoritaires varie.

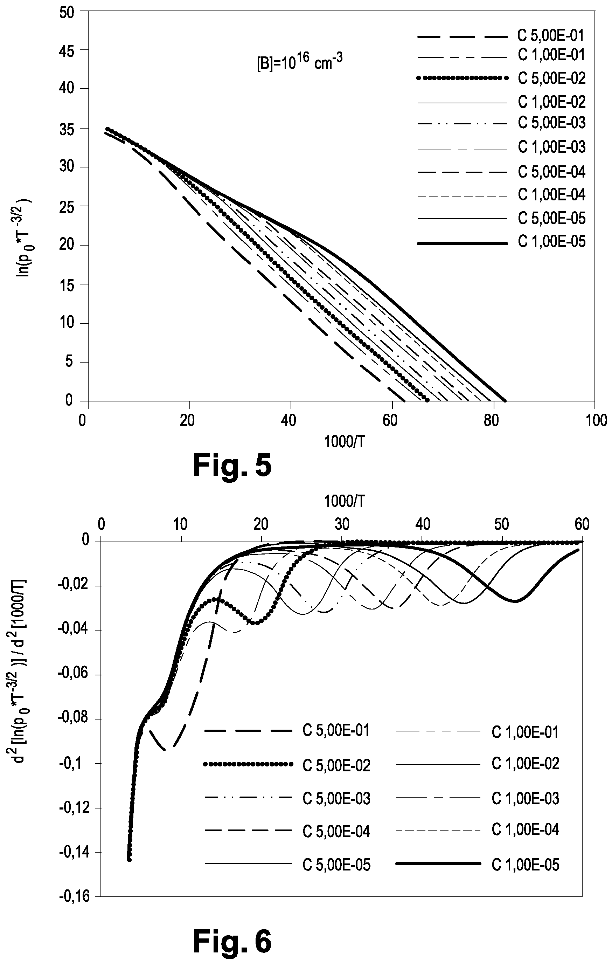

On procède ensuite à une étape 420 consistant à tracer, pour chaque degré de compensation, une courbe représentant le logarithme de la densité de porteurs de charge en fonction de l'inverse de la température (ou préférentiellement selon la relation (3)). La figure 5 montre un exemple de courbes pour un échantillon de silicium de type p dopé au bore à une concentration de $10^{16}$ cm$^{-3}$, le degré de compensation variant de $10^{-5}$ à $5.10^{-1}$.

Ensuite, la dérivée seconde de chaque courbe de la figure 5 (i.e. pour chaque degré de compensation), est calculée au cours d'une étape 430. La figure 6 montre le tracé, pour chaque degré de compensation, de la dérivée seconde pour l'échantillon de la figure 5.

Puis, pour chaque degré de compensation, on détermine au cours d'une étape 440 la position du minimum local de la dérivée seconde ayant la plus faible température. Il peut en effet exister plusieurs miniums locaux (par exemple au nombre de deux sur la figure 6, celui ayant la plus forte température correspondant à la transition entre les régimes R2 et R3) mais seul celui ayant la plus faible température correspond au changement de pente du régime d'ionisation R3.

Enfin, au cours d'une étape 450, l'abaque est établi en traçant la position du changement de pente (déterminée à l'étape 440) en fonction de la concentration des impuretés dopantes minoritaires, qui découle des degrés de compensation choisis à l'étape 410.

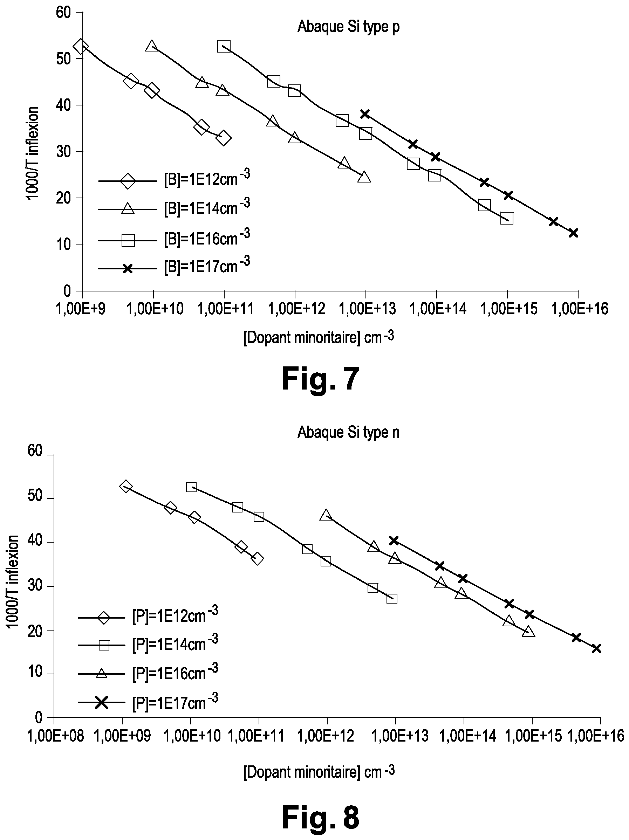

La figure 7 montre un abaque construit pour quatre échantillons de silicium de type p dopés au bore à des concentrations de $10^{12}$ cm$^{-3}$, $10^{14}$ cm$^{-3}$, $10^{16}$ cm$^{-3}$ et $10^{17}$ cm$^{-3}$.

On peut alors en déduire une expression empirique reliant la température $T_{CP}$ à laquelle survient le changement de pente et la concentration des dopants minoritaires telle que :

$$\frac{1000}{T_{CP}} = a * ln([Dopants\ minoritaires]) + b \qquad (4)$$

avec $T_{CP}$ en degré Kelvin et [*Dopants minoritaires*] en $cm^{-3}$. Les coefficients a et b de l'expression (4) ci-dessus, calculés à partir de l'abaque de la figure 7, sont reportés dans le tableau 1 ci-dessous :

**Tableau 1**

| [B] initiale ($cm^{-3}$) | Limite haute d'application | Coefficient a | Coefficient b |
|---|---|---|---|
| $10^{12}$ | $10^{11}$ | -4.225 | 140.17 |
| $10^{14}$ | $10^{13}$ | -3.984 | 144.08 |
| $10^{16}$ | $10^{15}$ | -3.877 | 150.46 |
| $10^{17}$ | $10^{16}$ | -3.699 | 148.99 |

En utilisant la même démarche, on peut construire le même type d'abaque pour quatre échantillons de silicium de type n dopés au phosphore à des concentrations de $10^{12}$ $cm^{-3}$, $10^{14}$ $cm^{-3}$, $10^{16}$ $cm^{-3}$ et $10^{17}$ $cm^{-3}$, comme illustré à la figure 8. Les coefficients a et b de l'expression (4), calculés à partir de l'abaque de la figure 8, sont reportés dans le tableau 2 ci-dessous :

**Tableau 2**

| [P] initiale ($cm^{-3}$) | Limite haute d'application | Coefficient a | Coefficient b |
|---|---|---|---|
| $10^{12}$ | $10^{11}$ | -3.728 | 130.5 |
| $10^{14}$ | $10^{13}$ | -3.814 | 141.21 |
| $10^{16}$ | $10^{15}$ | -3.791 | 149.71 |
| $10^{17}$ | $10^{16}$ | -3.668 | 149.84 |

Dans une variante de mise en oeuvre de l'étape 350, la concentration en impuretés dopantes minoritaires peut être calculée par un processeur à partir de la relation (4) (les coefficients a et b étant par exemple enregistrés dans une mémoire du processeur), plutôt que visuellement au moyen de l'abaque.

L'exemple qui suit va maintenant décrire une application concrète du procédé selon l'invention.

Dans cet exemple, on cherche à déterminer la contamination introduite par un four de recuit RTP (« Rapid Thermal Processing » en anglais), destiné par exemple à l'activation des dopants, à l'oxydation thermique du silicium ou au dépôt chimique en phase vapeur (CVD).

On considère deux échantillons de silicium non compensé de type n dopé au phosphore à des concentrations de $2,45.10^{16}$ $cm^{-3}$ et $1,73.10^{17}$ $cm^{-3}$. Les deux échantillons sont passés simultanément dans le four pour s'assurer qu'ils subissent le même traitement thermique.

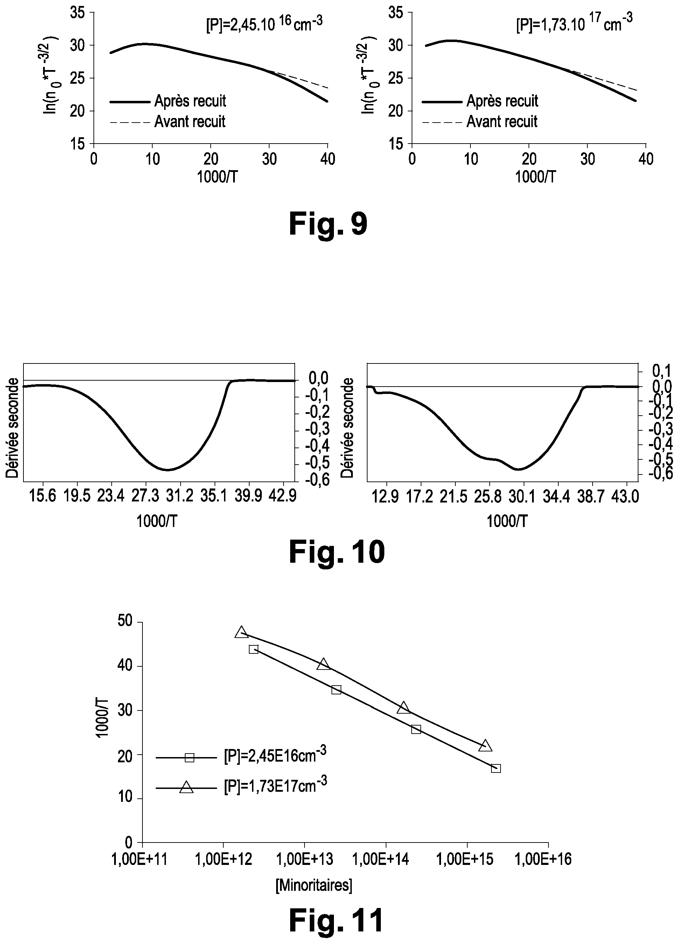

Les courbes représentant le logarithme de la densité de porteurs de charge selon la relation (3) sont tracées en fonction de l'inverse de la température (ici 1000/T), comme illustré à la figure 9, pour chaque échantillon, avant et après le recuit. Le tracé des courbes est effectué à partir des mesures de la densité de porteurs de charge en fonction de la température. On remarque pour chaque échantillon l'écart entre les courbes avant le recuit et après le recuit, et plus particulièrement le changement de pente dû à la contamination pour les plus faibles températures (pour les grandes abscisses 1000/T).

La figure 10 représente la dérivée seconde du logarithme de la densité de porteurs de charge en fonction de l'inverse de la température, calculée pour les deux échantillons à partir des valeurs du logarithme après recuit. Pour chaque échantillon, le minimum de la dérivée seconde indique la position du changement de pente.

La figure 11 montre les abaques réalisés d'après le procédé de calibration de la figure 4, pour les deux échantillons ayant chacun sa propre concentration en dopants majoritaires ($2,45.10^{16}$ $cm^{-3}$ et $1,73.10^{17}$ $cm^{-3}$). Graphiquement ou à l'aide des coefficients a et b de l'expression (4) reportés dans le tableau 3 ci-dessous, on détermine, pour chacun des deux échantillons, la concentration en contaminants minoritaires à partir de la position du changement de pente.

**Tableau 3**

| [P] initiale ($cm^{-3}$) | Coefficient a | Coefficient b |
|---|---|---|
| $2,45.10^{16}$ | -3,802 | 151,81 |
| $1,73.10^{17}$ | -3,73 | 153,03 |

Les valeurs des concentrations en contaminants minoritaires sont reportées dans le tableau 4 ci-dessous :

**Tableau 4**

| [P] initiale (cm$^{-3}$) | 1000/Tinf | [Minoritaires] (cm$^{-3}$) |
|---|---|---|
| 2,45.10$^{16}$ | 29,7 | 8,9.10$^{13}$ |
| 1,73.10$^{17}$ | 32,9 | 9,7.10$^{13}$ |

Il est à noter que les valeurs des concentrations des contaminants minoritaires obtenues pour les deux échantillons sont proches, validant ainsi le procédé de détermination de la contamination. La concentration totale des contaminants minoritaires est élevée, de l'ordre de 10$^{14}$ cm$^{-3}$. Le four étudié est donc très contaminé, ce qui est cohérent puisqu'il s'agit dans cet exemple d'un four de recuit de contacts métalliques pour la fabrication de cellules photovoltaïques. Des pâtes métalliques contenant par exemple de l'aluminium ou de l'argent sont régulièrement introduits dans le four, et ce dernier est constitué en partie de métaux comme le fer.

Un échantillon de silicium non compensé de type p dopé au bore à une concentration de 4.10$^{16}$ cm$^{-3}$ est également soumis au recuit RTP pour vérifier si le four introduit une contamination ayant un type de conductivité opposé à celui de la contamination détectée dans les échantillons de type n.

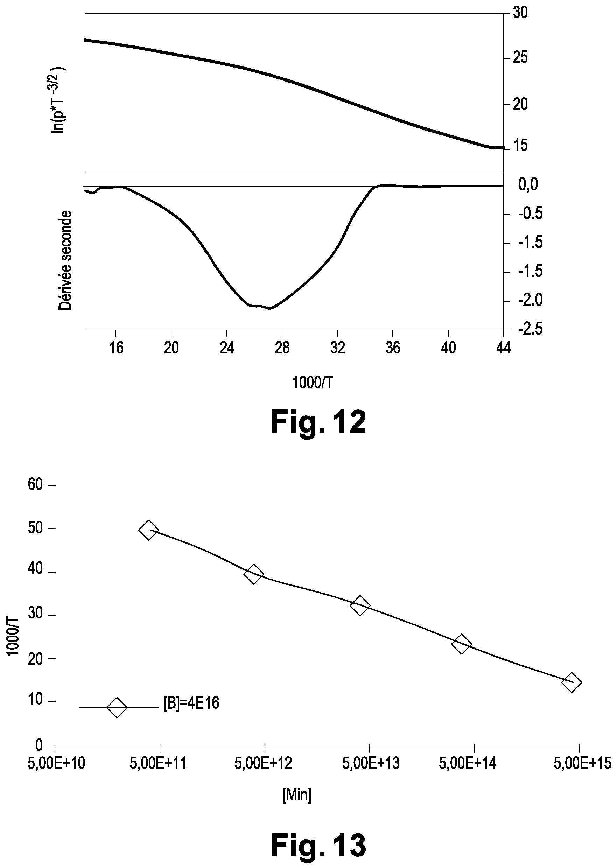

De la même manière que précédemment, les courbes représentant le logarithme de la densité de porteurs de charge selon la relation (3) ainsi que sa dérivée seconde sont tracées en fonction de l'inverse de la température (ici 1000/T), comme illustré à la figure 12, pour l'échantillon considéré, après recuit. Le tracé de la courbe du logarithme (en haut sur la figure 12) est effectué à partir des mesures de la densité de porteurs de charge en fonction de la température. La dérivée seconde du logarithme de la densité de porteurs de charge en fonction de l'inverse de la température (en bas sur la figure 12) est calculée à partir des valeurs du logarithme après recuit. Le minimum de la dérivée seconde indique la position du changement de pente.

La figure 13 montre l'abaque réalisé d'après le procédé de calibration de la figure 4, pour l'échantillon ayant une concentration en dopants majoritaires de 4.10$^{16}$ cm$^{-3}$. Graphiquement ou à l'aide des coefficients a et b de l'expression (4) reportés dans le tableau 5 ci-dessous, on détermine la concentration en contaminants minoritaires dans l'échantillon à partir de la position du changement de pente.

**Tableau 5**

| [B] initiale (cm$^{-3}$) | Coefficient a | Coefficient b |
|---|---|---|
| 4.10$^{16}$ | -3,852 | 152,15 |

Les valeurs des concentrations en contaminants minoritaires sont reportées dans le tableau 6 ci-dessous :

**Tableau 6**

| [B] initiale (cm$^{-3}$) | 1000/Tinf | [Minoritaires] (cm$^{-3}$) |
|---|---|---|
| 4.10$^{16}$ | 27,1 | 1,3.10$^{14}$ |

La concentration totale des contaminants minoritaires est élevée, de l'ordre de 10$^{14}$ cm$^{-3}$. Le four de recuit RTP introduit donc à la fois une contamination de type p et une contamination de type n.

Le procédé selon l'invention permet de détecter de très faibles valeurs de contamination, car le phénomène de double pente est visible pour les faibles degrés compensation (il est même d'autant plus visible que le degré de compensation est faible). Des concentrations théoriques en contaminants aussi faibles que 10$^{9}$ cm$^{-3}$ peuvent ainsi être détectées. Cette plus faible valeur de la concentration des contaminants qu'il est possible de déterminer correspond au dopage de fond du matériau semi-conducteur, c'est-à-dire sa limite de purification.

Bien que le procédé de détermination de la contamination ci-dessus ait été décrit en relation avec des échantillons en silicium, d'autres matériaux semi-conducteurs peuvent être utilisés, notamment les matériaux semi-conducteurs de type IV comme le germanium et les alliages silicium-germanium.

**Revendications**

1.  Procédé de détermination d'une contamination introduite par un équipement au sein de deux échantillons constitués d'un matériau semi-conducteur non compensé en impuretés dopantes, les deux échantillons ayant des types de conductivité opposés et comportant chacun des impuretés dopantes majoritaires dont le type de conductivité et la concentration sont connus, **caractérisé en ce que** le procédé comporte les différentes étapes consistant à :

a) soumettre (310) chacun des deux échantillons à un traitement thermique dans l'équipement, la contamination introduite par l'équipement lors du traitement thermique se traduisant par l'apparition d'impuretés dopantes, dont le type de conductivité et la concentration sont inconnus, au sein des deux échantillons, les impuretés dopantes dues à la contamination étant minoritaires dans au moins un des deux échantillons traités ;

b) mesurer (320) dans chacun des deux échantillons traités la densité de porteurs de charge en fonction de la température ;

c) définir (330) pour chacun des deux échantillons traités une courbe représentant le logarithme de la densité de porteurs de charge en fonction de l'inverse de la température ;

d) détecter (340), pour ledit au moins un des deux échantillons traités, la position d'un changement de pente dans une zone de la courbe correspondant à un régime d'ionisation des impuretés dopantes ; et

e) déterminer (350) la concentration des impuretés dopantes minoritaires dudit au moins un des deux échantillons traités à partir de la position du changement de pente.

2. Procédé selon la revendication précédente **caractérisé en ce que** les étapes a) à e) sont répétées pour une pluralité d'échantillons d'un même type de conductivité et ayant des concentrations en impuretés dopantes majoritaires différentes.

3. Procédé selon l'une quelconque des revendications précédentes **caractérisé en ce que** la courbe représentant le logarithme de la densité de porteurs de charge en fonction de l'inverse de la température est définie en étant tracée graphiquement.

4. Procédé selon l'une quelconque des revendications précédentes **caractérisé en ce que** la concentration des impuretés dopantes minoritaires dudit au moins un des deux échantillons traités est déterminée au moyen d'un abaque associé à la concentration connue en impuretés dopantes majoritaires.

5. Procédé selon la revendication précédente **caractérisé en ce que** l'abaque associé à la concentration connue en impuretés dopantes majoritaires est une courbe représentant la position du changement de pente en fonction de la concentration des impuretés dopantes minoritaires.

6. Procédé selon la revendication précédente **caractérisé en ce que** l'abaque associé à la concentration connue en dopants majoritaires est obtenu à l'aide des étapes suivantes :

- calculer (410) la densité de porteurs de charge en fonction de la température pour une pluralité de degrés de compensation, chaque degré de compensation étant défini comme le rapport entre une concentration en impuretés dopantes minoritaires et la concentration connue des impuretés dopantes majoritaires ;

- tracer (420), pour chaque degré de compensation, une courbe représentant le logarithme de la densité de porteurs de charge en fonction de l'inverse de la température ;

- calculer (430), pour chaque degré de compensation, la dérivée seconde de la courbe représentant le logarithme de la densité de porteurs de charge en fonction de l'inverse de la température ;

- déterminer (440), pour chaque degré de compensation, la position du minimum local de la dérivée seconde ayant la plus faible température et correspondant à un changement de pente dans une zone de la courbe correspondant à un régime d'ionisation des dopants ;

- tracer (450) une courbe représentant la position du changement de pente en fonction de la concentration en impuretés dopantes minoritaires.

7. Procédé selon l'une quelconque des revendications précédentes **caractérisé en ce que** la contamination introduite par l'équipement lors du traitement thermique se traduit par l'apparition, au sein de l'un des deux échantillons traités, d'impuretés dopantes minoritaires d'un premier type de conductivité, et par l'apparition, au sein de l'autre des deux échantillons traités, d'impuretés dopantes minoritaires d'un deuxième type de conductivité opposé au premier type de conductivité, les étapes d) et e) étant réalisées pour les deux échantillons traités.

8. Procédé selon l'une quelconque des revendications précédentes **caractérisé en ce que** les mesures de la densité de porteurs de charge sont effectuées à des températures comprises entre 20K et 300K.

9. Procédé selon l'une quelconque des revendications précédentes **caractérisé en ce que** la densité de porteurs de charge en fonction de la température est mesurée par effet Hall.

10. Procédé selon l'une quelconque des revendications précédentes **caractérisé en ce que** l'équipement est un four, le traitement thermique étant un recuit.

11. Procédé selon la revendication précédente **caractérisé en ce que** les deux échantillons sont soumis au recuit simultanément.

12. Procédé selon l'une quelconque des revendications 1 à 9 **caractérisé en ce que** l'équipement est un creuset, le traitement thermique de chacun des deux échantillons comprenant les différentes opérations consistant à :

  - fondre une charge du matériau semi-conducteur dans le creuset ;
  - cristalliser la charge du matériau semi-conducteur fondue sous la forme d'un lingot.

13. Procédé selon la revendication précédente **caractérisé en ce que** le traitement thermique de chacun des deux échantillons est suivi d'une opération consistant à découper une plaquette dans chacun des deux lingots.

**Patentansprüche**

1. Verfahren zur Bestimmung einer Kontamination, die durch eine Ausrüstung innerhalb von zwei Proben eingeführt ist, die aus einem durch nichtdopende Unreinheiten kompensierten Halbleitermaterial gebildet sind, wobei die zwei Proben entgegengesetzte Leitfähigkeitstypen haben und jeweils mehrheitliche dopende Unreinheiten aufweisen, deren Leitfähigkeitstyp und die Konzentration bekannt sind, **dadurch gekennzeichnet, dass** das Verfahren die unterschiedlichen Schritte aufweist, bestehend aus:

   a) Unterwerfung (310) jeder der zwei Proben einer thermischen Behandlung in der Ausrüstung, wobei die durch die Ausrüstung bei der thermischen Behandlung eingeführte Kontamination durch das Auftreten von dopenden Unreinheiten innerhalb der zwei Proben zum Ausdruck kommt, deren Leitfähigkeitstyp und die Konzentration unbekannt sind, wobei die dopenden Unreinheiten aufgrund der Kontamination in wenigstens einer der zwei behandelten Proben minoritär ist;
   b) Messung (320) der Dichte der Chargenträger in Abhängigkeit von der Temperatur in jeder der zwei behandelten Proben;
   c) Definition (330) einer Kurve, die den Logarithmus der Dichte des Chargenträgers in Abhängigkeit von der Umkehrung der Temperatur darstellt, für jede der zwei behandelten Proben;
   d) Detektion (340) der Position einer Neigungsänderung in einem Bereich der Kurve, der einem Ionisationsbetrieb der dopenden Unreinheiten entspricht, für die genannte wenigstens eine der zwei behandelten Proben; und
   e) Bestimmung (350) der Konzentration der minoritären dopenden Unreinheiten der genannten wenigstens einen der zwei behandelten Proben ausgehend von der Position der Neigungsänderung.

2. Verfahren gemäß dem voranstehenden Anspruch, **dadurch gekennzeichnet, dass** die Schritte a) bis e) für eine Vielzahl von Proben eines und desselben Leitfähigkeitstyps wiederholt werden und unterschiedliche Konzentrationen an mehrheitlichen dopenden Unreinheiten haben.

3. Verfahren gemäß irgendeinem der voranstehenden Ansprüche, **dadurch gekennzeichnet, dass** die Kurve, die den Logarithmus der Dichte des Chargenträgers in Abhängigkeit von der Umkehrung der Temperatur darstellt, per grafischer Darstellung definiert ist.

4. Verfahren gemäß irgendeinem der voranstehenden Ansprüche, **dadurch gekennzeichnet, dass** die Konzentration der mehrheitlichen dopenden Unreinheiten der genannten wenigstens einen der zwei behandelten Proben mittels eines Abakus bestimmt wird, der der bekannten Konzentration an mehrheitlichen dopenden Unreinheiten zugeordnet ist.

5. Verfahren gemäß dem voranstehenden Anspruch, **dadurch gekennzeichnet, dass** der Abakus, der der bekannten Konzentration an mehrheitlichen dopenden Unreinheiten zugeordnet ist, eine Kurve ist, die die Position der Neigungsänderung in Abhängigkeit von der Konzentration der minoritären dopenden Unreinheiten darstellt.

**6.** Verfahren gemäß dem voranstehenden Anspruch, **dadurch gekennzeichnet, dass** der Abakus, der der bekannten Konzentration an mehrheitlichen Dopanten zugeordnet ist, mithilfe der folgenden Schritte erhalten wird:

- Berechnung (410) der Dichte der Chargenträger in Abhängigkeit von der Temperatur für eine Vielzahl von Kompensationsgraden, wobei jeder Kompensationsgrad als das Verhältnis zwischen einer Konzentration an minoritären dopenden Unreinheiten und der bekannten Konzentration an mehrheitlichen dopenden Unreinheiten definiert ist;
- Trassieren (420) einer Kurve, die den Logarithmus der Dichte des Chargenträgers in Abhängigkeit von der Umkehrung der Temperatur darstellt, für jeden Kompensationsgrad;
- Berechnung (430) der zweiten Ableitung der Kurve, die den Logarithmus der Dichte des Chargenträgers in Abhängigkeit von de Umkehrung der Temperatur darstellt, für jeden Kompensationsgrad;
- Bestimmung (440) der Position des lokalen Minimums der zweiten Ableitung, die die niedrigste Temperatur hat und einer Änderung der Last in einem Bereich der Kurve entspricht, die einem Ionisationsbetrieb der Dopanten entspricht, für jeden Kompensationsgrad;
- Trassieren (450) einer Kurve, die die Position der Neigungsänderung in Abhängigkeit von der Konzentration an minoritären dopenden Unreinheiten darstellt.

**7.** Verfahren gemäß irgendeinem der voranstehenden Ansprüche, **dadurch gekennzeichnet, dass** die Kontamination, die von der Ausrüstung bei der thermischen Behandlung eingeführt wird, durch das Auftreten von minoritären dopenden Unreinheiten eines ersten Leitfähigkeitstyps in einer der zwei behandelten Proben zum Ausdruck kommt und durch das Auftreten von minoritären dopenden Unreinheiten eines dem ersten Leitfähigkeitstyp entgegengesetzten zweiten Leitfähigkeitstyps in der anderen der zwei behandelten Proben zum Ausdruck kommt, wobei die Schritte d) und e) für die zwei behandelten Proben realisiert sind.

**8.** Verfahren gemäß irgendeinem der voranstehenden Ansprüche, **dadurch gekennzeichnet, dass** die Messungen der Dichte der Chargenträger bei zwischen 20K und 300K inbegriffenen Temperaturen durchgeführt werden.

**9.** Verfahren gemäß irgendeinem der voranstehenden Ansprüche, **dadurch gekennzeichnet, dass** die Dichte der Chargenträger in Abhängigkeit von der Temperatur per Hall-Effekt gemessen wird.

**10.** Verfahren gemäß irgendeinem der voranstehenden Ansprüche, **dadurch gekennzeichnet, dass** die Ausrüstung ein Ofen ist, wobei die thermische Behandlung ein Nachglühen ist.

**11.** Verfahren gemäß dem voranstehenden Anspruch, **dadurch gekennzeichnet, dass** die zwei Proben gleichzeitig dem Nachglühen unterzogen werden.

**12.** Verfahren gemäß irgendeinem der Ansprüche 1 bis 9, **dadurch gekennzeichnet, dass** die Ausrüstung ein Schmelztiegel ist, wobei die thermische Behandlung jeder der beiden Proben die unterschiedlichen Operationen umfasst, bestehend aus:

- Schmelzen einer Charge des Halbleitermaterials in dem Schmelztiegel:
- Kristallisieren der geschmolzenen Charge des Halbleitermaterials in Form eines Gussblocks.

**13.** Verfahren gemäß dem voranstehenden Anspruch, **dadurch gekennzeichnet, dass** auf die thermische Behandlung jeder der zwei Proben eine Operation folgt, die aus dem Ausschneiden einer Plakette aus jedem der zwei Gussblöcke besteht.

## Claims

**1.** Method for determining contamination introduced by an equipment within two samples comprised of a semiconductor material uncompensated in dopant impurities, the two samples having opposite types of conductivity and each comprising majority dopant impurities of which the type of conductivity and concentration are known, **characterised in that** the method comprises the different steps consisting in:

a) subjecting (310) each of the two samples to a heat treatment in the equipment, the contamination introduced by the equipment during the heat treatment resulting in the appearance of dopant impurities, of which the type of conductivity and concentration are unknown, within the two samples, the dopant impurities due to the contamination being minority in at least one of the two treated samples;

b) measuring (320) in each of the two treated samples the charge carrier density as a function of temperature;

c) defining (330) for each of the two treated samples a curve representing the logarithm of the charge carrier density as a function of the inverse of temperature;

d) detecting (340), for said at least one of the two treated samples, the position of a change in slope in an area of the curve corresponding to an ionisation regime of the dopant impurities; and

e) determining (350) the concentration of minority dopant impurities of said at least one of the two treated samples from the position of the change in slope.

2. Method according to the preceding claim, **characterised in that** steps a) to e) are repeated for a plurality of samples of a same type of conductivity and having different concentrations of majority dopant impurities.

3. Method according to any of the preceding claims, **characterised in that** the curve representing the logarithm of the charge carrier density as a function of the inverse of temperature is defined by being plotted graphically.

4. Method according to any of the preceding claims, **characterised in that** the concentration of minority dopant impurities of said at least one of the two treated samples is determined using an abacus associated with the known concentration of majority dopant impurities.

5. Method according to the preceding claim, **characterised in that** the abacus associated with the known concentration of majority dopant impurities is a curve representing the position of the change in slope as a function of the concentration of minority dopant impurities.

6. Method according to the preceding claim, **characterised in that** the abacus associated with the known concentration of majority dopants is obtained by means of the following steps:

- calculating (410) the charge carrier density as a function of temperature for a plurality of degrees of compensation, each degree of compensation being defined as the ratio between a concentration of minority dopant impurities and the known concentration of majority dopant impurities;
- plotting (420), for each degree of compensation, a curve representing the logarithm of the charge carrier density as a function of the inverse of temperature;
- calculating (430), for each degree of compensation, the second derivative of the curve representing the logarithm of the charge carrier density as a function of the inverse of temperature;
- determining (440), for each degree of compensation, the position of the local minimum of the second derivative having the lowest temperature and corresponding to a change in slope in an area of the curve corresponding to an ionisation regime of the dopants;
- plotting (450) a curve representing the position of the change in slope as a function of the concentration of minority dopant impurities.

7. Method according to any of the preceding claims, **characterised in that** the contamination introduced by the equipment during the heat treatment results in the appearance, within one of the two treated samples, of minority dopant impurities of a first type of conductivity, and by the appearance, within the other of the two treated samples, of minority dopant impurities of a second type of conductivity opposite to the first type of conductivity, steps d) and e) being carried out for the two treated samples.

8. Method according to any of the preceding claims, **characterised in that** the measurements of the charge carrier density are carried out at temperatures comprised between 20K and 300K.

9. Method according to any of the preceding claims, **characterised in that** the charge carrier density as a function of temperature is measured by Hall effect.

10. Method according to any of the preceding claims, **characterised in that** the equipment is a furnace, the heat treatment being an annealing.

11. Method according to the preceding claim, **characterised in that** the two samples are subjected to annealing simultaneously.

12. Method according to any of claims 1 to 9, **characterised in that** the equipment is a crucible, the heat treatment of each of the two samples comprising the different operations consisting in:

- melting a charge of the semiconductor material in the crucible;
- crystallising the melted charge of semiconductor material in the form of an ingot.

13. Method according to the preceding claim, **characterised in that** the heat treatment of each of the two samples is followed by an operation consisting in cutting out a wafer in each of the two ingots.

**Fig. 1**

**Fig. 2**

| -310- | Soumettre chacun des deux échantillons à un traitement thermique dans l'équipement |
| -320- | Mesurer dans chacun des deux échantillons traités la densité de porteurs de charge en fonction de la température |
| -330- | Tracer pour chacun des deux échantillons traités une courbe représentant le logarithme de la densité de porteurs de charge en fonction de l'inverse de la température |
| -340- | Détecter pour au moins un des deux échantillons traités la position d'un changement de pente |
| -350- | Déterminer la concentration des impuretés dopantes minoritaires à partir de la position du changement de pente au moyen d'un abaque |

# Fig. 3

| -410- | Calculer la densité de porteurs de charge en fonction de la température pour une pluralité de degrés de compensation |
|---|---|

| -420- | Tracer pour chaque degré de compensation une courbe représentant le logarithme de la densité de porteurs de charge en fonction de l'inverse de la température |
|---|---|

| -430- | Calculer pour chaque degré de compensation la dérivée seconde de la courbe représentant le logarithme de la densité de porteurs de charge en fonction de l'inverse de la température |
|---|---|

| -440- | Déterminer pour chaque degré de compensation la position du minimum local de la dérivée seconde ayant la plus faible température et correspondant à un changement de pente |
|---|---|

| -450- | Tracer une courbe représentant la position du changement de pente en fonction de la concentration en impuretés dopantes minoritaires |
|---|---|

# Fig. 4

**Fig. 5**

**Fig. 6**

Fig. 7

Fig. 8

**Fig. 9**

**Fig. 10**

**Fig. 11**

Fig. 12

Fig. 13